# EUROPEAN PATENT APPLICATION

(11) **EP 4 764 701 A1**
(43) Date of publication of application: **24.06.2026**
(21) Application number: 24222735.3
(22) Date of filing: 23.12.2024
(51) Int. Cl.: G03F 7/00, H01L 21/687

(54) **OBJECT HOLDER**

(71) Applicant: ASML Netherlands B.V., 5500 AH Veldhoven (NL)
(72) Inventor: ALLSOP, Nicholas, Alan, 5500 AH Veldhoven (NL); WAACK, Erik, 5500 AH Veldhoven (NL); MEZERA, Marek, 5500 AH Veldhoven (NL)
(74) Representative: ASML Netherlands B.V.

(57) **Abstract**

There is provided an object holder configured to support an object used in an exposure apparatus for a semiconductor manufacturing process, the object holder comprising a plurality of support elements, wherein the plurality of support elements define a support surface, wherein the plurality of support elements comprise at least two layers; wherein a first of the at least two layers is a substoichiometric chromium based layer or a metal-Si multilayer or a metal-Ge multilayer, configured to provide a selectively changeable height of individual support elements via thermal treatment of the first layer; wherein a second of the at least two layers is more compressively stressed than the first of the at least two layers, and wherein the second layer is located closer to a free end of the support element than said first layer, wherein a layer thickness of said first layer of at least some of the plurality of support elements has been reduced via thermal laser treatment. Also described is an optical element for an exposure apparatus for a semiconductor manufacturing process, an exposure apparatus for a semiconductor manufacturing process, such as a lithographic apparatus or tool, and a method of correcting the flatness of a surface of an object holder or optical element of an exposure apparatus for a semiconductor manufacturing process.

## Description

### FIELD

The present disclosure relates to an object holder, an object table, an optical element, and an exposure apparatus for semiconductor manufacturing processes, such as a lithographic apparatus or tool, comprising such an object holder, optical element, or object table. The present disclosure also relates to a method of controlling the flatness of a surface. Also described is the use of such an object holder, object table, exposure apparatus for a semiconductor manufacturing process, such as a lithographic apparatus, or methods in a semiconductor manufacturing process, such as a lithographic method or apparatus. The object holder may be part of an object table of an exposure apparatus for a semiconductor manufacturing process, such as a lithographic apparatus or lithographic tool. The present disclosure has particular, but not exclusive, application to EUV and DUV lithographic apparatuses and methods as well as in inspection apparatuses and methods as well as metrology apparatuses and methods.

### BACKGROUND

Light generated by means of a radiation source can be used by exposure apparatuses for semiconductor manufacturing processes. Examples of such exposure apparatuses are a lithographic apparatus, a metrology, or an inspection apparatus, such as a mask inspection apparatus or an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The substrate to be exposed may be supported by a substrate holder (i.e. the object that directly supports a substrate), which in turn is supported by a substrate table. The substrate holder may have an array of projections or support elements, referred to as burls, projecting from at least one side. When the substrate rests on the top of the burls on the at least one side of the substrate holder, the substrate may be spaced apart from a main body of the substrate holder. This may aid in the prevention of a particle (i.e. a contaminating particle such as a dust particle), which may be present on the substrate holder, from distorting the substrate holder or substrate. The total surface area of the burls may only be a small fraction of the total area of the substrate or substrate holder. As such, it is more probable that any particle will lie between burls and its presence will have no effect. The tops of the burls define a plane, also referred to as a support surface, on which objects lie when engaged therewith.

Due to the high accelerations that may be experienced by the substrate in use of a high-throughput lithographic apparatus, it may not be sufficient to allow the substrate simply to rest on the burls of the substrate holder. It is clamped in place. Two methods of clamping the substrate in place may be used - vacuum clamping and electrostatic clamping. In vacuum clamping, the space between the substrate holder and substrate and optionally between the substrate table and substrate holder are partially evacuated so that the substrate is held in place by the higher pressure of gas or liquid above it. Vacuum clamping, however, may not be used where the beam path and/or the environment near the substrate or substrate holder is kept at a low or very low pressure, e.g. for extreme ultraviolet (EUV) radiation lithography. In this case, it may not be possible to develop a sufficiently large pressure difference across the substrate (or substrate holder) to clamp it. Electrostatic clamping may, therefore, be used. In electrostatic clamping, a potential difference is established between the substrate and the substrate table and/or substrate holder. The potential difference may generate a clamping force.

It is important to control the flatness of the substrate, which may be, for example, a wafer. Whilst a substrate may have a flatness which is within specification when it is not in situ within a lithographic apparatus, the flatness may change when the substrate is held in position within a lithographic apparatus due to the forces acting upon it, such as those from electrostatic or vacuum clamping. In this way, the so-called functional flatness of the substrate, namely the flatness when in position for use, needs to be controlled as although the free substrate may be within specification, an in-situ substrate may not. Similarly, it is desirable to provide optical elements, such as mirror blocks, with optimised surface shapes to achieve optimal results and accuracy.

In use, surfaces are subject to wear and tear as well as contamination, and the flatness of surfaces can be negatively affected. The surfaces may be subject to uneven wear and tear, which limits performance and limits the lifetime of the component. For example, the flatness of the support surface spanned by the tops, or, end faces of the burls may be compromised by a notch on the surface of the object holder. A notch may be caused by a mechanical influence, such as by a foreign particle (notch damage), for example. The notch may be caused, for example, on the end face of a burl by sharp or pointed particles which adhere to the rear side of a semiconductor wafer when it is pressed against the support surface during processing.

The notch, which acts locally as an indentation, may not directly compromise the flatness of the support surface. However, in the vicinity of the notch, a local pile up or bulging may occur due to material displacement as a result of the penetrating foreign particle, which compromises the flatness.

Notch damage may limit the useful life of an object holder. The replacement of object holders results in high costs due to downtime and due to the processing of the object holder. Therefore, there is an interest in minimising notch damage.

The present disclosure has been devised in an attempt to address at least some of the problems identified above.

### SUMMARY

According to a first aspect of the invention there is provided an object holder configured to support an object used in an exposure apparatus for a semiconductor manufacturing process, the object holder comprising a plurality of support elements, wherein the plurality of support elements define a support surface, wherein the plurality of support elements comprise at least two layers; wherein a first of the at least two layers is a substoichiometric chromium based layer or a metal-Si multilayer or a metal-Ge multilayer, configured to provide a selectively changeable height of individual support elements via thermal treatment of the first layer; wherein a second of the at least two layers is more compressively stressed than the first of the at least two layers, and wherein the second layer is located closer to a free end of the support element than said first layer, wherein a layer thickness of said first layer of at least some of the plurality of support elements has been reduced via thermal laser treatment. The plurality of support elements may be a plurality of burls. The metal may be selected from titanium, molybdenum, or any combination thereof.

The flatness of object holders, particularly those for exposure apparatus for semiconductor manufacturing processes, such as wafer tables and wafer clamps, is adjusted by one of two methods. Firstly, ion-beam figuring (IBF) adjusts the flatness by etching the surface of the object holder by ion bombardment in an offline setup. By offline setup, it will be understood that this is outside of a lithographic apparatus used for imaging wafers. It is possible to correct the heights of individual burls, and the ability to do this is determined by the spot size of the ion beam. It is not possible to undertake IBF within a lithographic scanner as it requires an ion source and the removal of the material would cause contaminant materials to spread within the scanner and cause contamination issues. In operation, the flatness may drift due to a variety of reasons including wear, indentation, and contamination. The flatness provides a strong contribution to On Product Overlay (OPO) and the need to replace clamps, which involves long downtimes, is driven by flatness degradation. Similarly, with optical elements, such as mirror blocks, flatness correction takes place using IBF, after which the mirror coating is applied and the surface flatness can no longer be corrected. Laser ablation can be used to remove material from a target, but this has a minimum height removal of around 40 to 60 nm per pulse, which limits it suitability since the difference in height of support element which causes focus problems and lost dies is less than this. As such, laser ablation would remove too much material and could also generate unwanted contaminants.

The present disclosure addresses the shortcomings of existing techniques, by providing a material which can be heated to alter the height of individual support elements. Although it will be appreciated that materials contract and expand upon temperature change, this does not allow for the stable change in height of support elements, such as burls, whereas the use of materials which undergo a phase transition allows such changes in height to be stable. By stable it is understood that the phases does not change at the operating temperatures experienced in nominal use and over the timescale over which the object holder is in nominal use. In this way, the present disclosure allows for individual support elements, such a burls, to be adjusted in the final stages of the object holder manufacturing process and/or during the lifetime of the object holder. Since the height of the burls are adjusted without the removal of material, the adjustment may even be effected within a scanner. This is further advantageous since the functional flatness of a substrate can differ between scanners, and it is not possible to correct for this external to the scanner. The present disclosure allows for the support surface to be made flat or unflat in order to correct for differences between individual scanners and ultimately provide a functional flatness that corrects for overlay and/or focus errors of other parts of the system, for example to correct for non-ideal focus plane and bring a specific wafer into focus. When a Ti-Si multilayer is heated, the formation of TiSi and/or TiSi₂ resulting in a dimensional change. A similar effect is seen for metal-germanium multilayers. Similarly, it has been found that a chromium based layer may be densified, and therefore reduced in volume, by selective heating. It has been found that regarding chromium based layers, a substoichiometric chromium nitride layer provides the most useful amount of shrinkage. Such a reduction in volume can be utilised to adjust the height of a support element. The formula of the Ti-Si multilayer may be TiSiₓ wherein 0.3 ≤ x ≤ 2. The Ti-Si multilayer may comprise any number of alternating layers of Ti and Si. Similarly, for a Mo-Si multilayer, this may comprise any number of alternating layers of Mo and Si. Similarly, for a metal-Ge multilayer, any number of alternating layers of Ge and metal may be used. The formula of the metal-Ge multilayer may be MGeₓ wherein 0.3 ≤ x ≤ 2. It will be appreciated that the multilayer may include different metals, which may be in the same layer, and/or in different layers. The thickness of each individual layer in the multilayer may be from around 2 nm to around 100 nm, and are preferably from around 10 to around 20nm, in thickness. The layers may be provided by sputtering, optionally magnetron sputtering. It will be appreciated that not all of the support elements necessarily comprise the multilayer. Preferably, the support elements which are subject to most wear in operation are provided with the multilayer.

For example, burls which have an increased height of 12 nm or more, which may be caused by indentations or contamination issues, are sufficient to cause focus problems and lost dies. At the edge of the support surface, the support elements are subject to wear and can be worn down in use by from around 20 to 50 nm, which limits performance. Both of these effects limits the lifetime of the support surface and can lead to premature replacement and associated downtime. By being able to correct the height of the support elements, the desired shape of the support surface can be adjusted and the lifetime of the support surface can thereby be extended. In addition, issues caused by wear and tear on the burls may be addressed by decreasing the height of surrounding burls, resulting in a more gradual change in flatness. A more gradual change in flatness may generally be more easily correctable by other means within an exposure apparatus during exposure.

It has also been found that adjusting the height of individual support elements increases the likelihood of cracks forming and so the degree of height adjustment available is limited to reduce the risk of such crack formation. The present disclosure addresses this limitation by providing a second layer which is located closer to a free end of the support element than the first layer, in particular the layer which is used to alter the height of the support element, and which is more compressively stressed than the first layer. It has been found that providing a more highly compressively stressed layer provides improved tolerance to height changes. The more compressively stressed layer mitigates cracking and therefore avoids damage to the individual support elements and also allows for greater height control to be realised.

As mentioned, a layer thickness of said first layer of at least some of the plurality of the support elements has been reduced via thermal laser treatment. As such, at least some of the plurality of support elements may have already been heat treated. As mentioned, by applying thermal energy from a laser, it is possible to cause a change in height of the selected materials, thereby changing the height of the support element.

The first layer may be a sub stoichiometric chromium based layer. The first layer may be a sub stoichiometric chromium nitride layer. The sub stoichiometric chromium nitride layer may have the formula CrₓN wherein 0.3 ≤ x ≤ 0.8. As mentioned, it has been found that the most useful height change is provided by sub stoichiometric chromium nitride.

The second layer may be a chromium based layer. The second layer may be a sub stoichiometric chromium nitride layer. The sub stoichiometric chromium nitride layer may have the formula CrₓN wherein 0.3 ≤ x ≤ 0.8. As such, the first and second layers may both be chromium based layers. The first and second layers may both be chromium nitride layers, but they have different compressive stresses. The second layer may be a titanium based layer, such as titanium nitride. The second layer may be a diamond-like carbon (DLC) layer, such as for example tetrahedral amorphous carbon. In particular, the second layer has a greater compressive stress than the first layer, which eliminates or significantly reduces the likelihood of cracking when the support element is changed in height.

The second layer of the at least two layers may have been deposited via a process which results in an increased compressive stress. The second layer of the at least two layers may have been deposited via HiPIMS (Hi Pulse Magnetron Sputtering). HiPIMS is a magnetron sputtering process which utilises a pulsed voltage provided over a short period of time, such as in the order of tens of microseconds. In this way, whilst the total amount of energy provided may be similar to other sputtering processes, it is delivered in higher powered pulses which result in a greater degree of ionisation of the sputtered materials, the production of energetic ions, and a high rate of gas dissociation which results in a high density of deposited material. In this way, it is possible to provide the second layer with a greater compressive stress than the first layer. The second layer may have been provided by other means, such as ion beam sputtering, magnetron sputtering with substrate bias, arc evaporation, or plasma enhanced chemical vapor deposition process. The deposition is controlled to provide a second layer with a greater compressive stress than the first layer.

The second layer may be a top layer at the free end of the support element. By top layer, it will be understood that this is the topmost layer and therefore is the layer which touches an object being supported by the object holder. At least some of the plurality of support elements may have a portion distal to the free end of the support element comprising silicon nitride.

The metal may be molybdenum, titanium, or any combination thereof.

The second of the at least two layers may have a compressive stress of from around 500 MPa to around 900 MPa, from around 600 MPa to around 800 MPa, at least 500 MPa, at least 600 MPa, at least 700 MPa, at least 800 MPa, at least 900 MPa, or at least 1000 MPa. As mentioned, by providing a second layer with a greater compressive stress than the first layer has been found to allow greater degrees of height change without cracking or at least with significantly reduced likelihood of cracking.

The second of the at least two layers may have a thickness of from around 500 nm to around 2000 nm.

At least some of the plurality of support elements may comprise one or more layers in addition to the first and second layers. Such additional one or more layers may comprise silicon nitride. Again, the additional layers may serve a different purpose than the first and/or second layers.

A third layer may be provided between the first and second layers. As such, the first and second layers do not necessarily have to be in direct contact with one another. A layer between the first and second layers may serve a different purpose. For example, the third layer may be a crumple zone, such as in the form of a notch absorption layer as referred to below, or the third layer may serve to improve adhesion between the first and second layers, for example.

At least one of the one or more additional layers may be at an opposite end to the free end. As such, at least one of the one or more additional layers may be provided on a base body and extend therefrom. In an embodiment, a lower part, or, base part of the burls may be integral with the base body. In an embodiment, the entire height of the burls is at least substantially formed by the first and second layers, optionally also including said third layer.

The object holder may incorporate the features described in WO2022268655, the content of which is hereby incorporated in its entirety. In particular, embodiments of the present disclosure include the object holder described herein with the notch absorption layer described in WO2022268655. As such, the object holder may include a base body having an upper side. The plurality of support elements may be arranged on the upper side of the base body and form a support surface with a predetermined flatness for contacting the object. The support elements may have a notch absorption layer which has such a low volume density that the notch absorption layer can be compacted in the layer volume in the case of mechanical action by a foreign particle without compromising the flatness of the support surface. As such, such a notch absorption layer may be the third layer or an additional layer as mentioned above. It will be appreciated that compaction occurs in the undesirable case where there is contamination between the support elements (the burls) and the object being supported, such as a wafer. As such, this is not the same as the compressively stressed second layer, which is provided as a compressively stressed layer during manufacture, whereas the notch absorption layer is not compressively stressed during manufacture in order to allow it to deform should there be a contaminant. If the notch absorption layer were compressively stressed, it would have less or no capacity to be compressed should there be a contaminant. In other words, the notch absorption layer can be compressed, meaning that it can change its volume or increase its density upon a compressive force being applied, which is not the same as a compressive stress.

As mentioned, the object holder may be an electrostatic holding device (also referred to as an electrostatic wafer clamp, electrostatic clamp device, electrostatic clamp, ESC, or electrostatic chuck) or a vacuum holding device (also referred to as a vacuum clamp or vacuum chuck). A spatial direction parallel to the support surface of the object holder is referred to as the lateral direction and direction perpendicular thereto is referred to as the thickness direction (z direction). In lateral directions, the base body preferably has a planar extent parallel to the support surface, and it can be formed from one or more boards stacked in the thickness direction and joined to one another. The upper side of the base body is the side that is provided for contacting and holding the object. When the object holder is adjusted to contact and/or hold objects on both sides, each side forms an upper side, in which case burls in accordance with the present disclosure may be provided on both sides of the object holder.

The structure of the notch absorption layer may contains cavities and spaces between the atomic constituents of the material of the notch absorption layer, so that the volume density and optionally also the hardness of the notch absorption layer is reduced in comparison with a material without microscopic gaps. As a result, a foreign particle that is pressed onto the support surface with a force component in the thickness direction can locally displace and compress the atomic constituents of the material of the notch absorption layer. The material in the layer volume of the notch absorption layer is compacted and is locally compressed in the vicinity of the foreign particle.

It has been found that compaction occurs primarily in the lateral direction and or in the thickness direction to the depth of the notch absorption layer, while local pile ups in the vicinity of the foreign particle over the thickness of the notch absorption layer are excluded or minimised to a negligible level. Advantageously, the compression of the notch absorption layer does not compromise the flatness of the support surface. Thus, the notch absorption layer is advantageously distinguished from a conventional impact absorption layer of a package in which surface projections are formed.

A further advantage is that the notch absorption layer enables reduced susceptibility to notch damage, because volumes of foreign particles are absorbed. Since the flatness is not compromised by foreign particle influences, especially during use of the object holder, the notch absorption layer delivers an extended useful life of the object holder. Furthermore, the notch absorption layer is easy to manufacture, and therefore the costs of the holding device are virtually unchanged in comparison with a conventional object holder, while the costs of using the object holder are considerably reduced on account of shortened downtimes. Finally, mechanical stresses as a result of particles are prevented or reduced to a negligible level.

The notch absorption layer may be a porous and/or fibrous layer with columnar growth. The provision of the porous and/or fibrous notch absorption layer has the advantage that the adjustment of the volume density, in particular the porosity or a fibre density or volume between the grains, is simplified during manufacture of the notch absorption layer, for example during a layer deposition from the vapour phase. Preferably, the porosity and/or fibre density is adjusted in such a way that the volume density of the notch absorption layer is selected to be in the range 90% to 10%, in particular in the range 85% to 10%, such as in the range 85% to 50% for example, of the volume density of the solid material of the notch absorption layer. Here, the term "solid material" refers to a single crystal with the same chemical composition and crystal structure as the notch absorption layer, or, if the material of the notch absorption layer does not form a single crystal and/or reliable data are not present, a theoretically defect-free material with the same composition and atomic structure as the notch absorption layer.

The notch absorption layer can be adjusted optimally to the structure and materials of the other components of the object holder. The notch absorption layer may be formed from a ceramic and/or a metal. For example, the notch absorption layer may consist of the ceramic or the metal, or may comprise a multilayer configuration with several ceramics or several metals, or a multilayer configuration with at least one ceramic and at least one metal. For example, the notch absorption layer can be formed from Crx N with 0.9 < x < 2.2 or a compound Crx My N with 0 < x < 2.2, in particular 0.3 < x < 2.2, and 0 < y < 1, wherein M comprises a further metal, in particular Al, Si or Ti. CrN and Crx My N have particular advantages in relation to the adjustment of the volume density of the notch absorption layer. Alternatively or in addition, the notch absorption layer can have a thickness in the range 300 nm to 20 pm, in particular in the range 500 nm to 5 pm.As mentioned, the plurality of support elements may be burls. It will be appreciated that not all of the support elements or burls need to include the metal-Si multilayer, metal-Ge multilayer, and/or sub stoichiometric chromium based layer. In embodiments, all of the support elements include a metal-Si multilayer, a metal-Ge multilayer, and/or a sub stoichiometric chromium based first and/or second layer. In other embodiments, only some of the support elements include a metal-Si multilayer, metal-Ge multilayer, and/or sub stoichiometric chromium based first or second layer. Preferably, in embodiments in which only some of the support elements include a metal-Si multilayer, a metal-Ge multilayer, and/or sub stoichiometric chromium based layer, the metal-Si multilayer, metal-Ge multilayer, and/or sub stoichiometric chromium based layer is provided to the support elements which are subject to the greatest wear and tear.

The object holder may be a substrate holder. The object holder may be a wafer holder, such as a wafer table or a wafer clamp, such as an electrostatic wafer clamp or a vacuum chuck. The object holder may be a reticle holder, such as a reticle clamp or reticle table. Indeed the substrate holder may be any holder which requires micrometer or nanometer accuracy in flatness.

The thickness of the metal-Si multilayer, metal-Ge multilayer, and/or sub stoichiometric chromium based layer may be up to around 1400 nm, up to around 1300 nm, up to around 1200 nm, up to around 1100 nm, up to around 1000 nm, up to around 900 nm, up to around 800 nm, up to around 700nm, up to around 600 nm, up to around 500 nm, up to around 400 nm, up to around 300 nm, up to around 200 nm or up to around 100 nm. The thickness of the metal-Si multilayer, metal-Ge multilayer, or sub stoichiometric chromium based layer can be selected to provide the desired range of height adjustment required for a given application. The thickness of the sub stoichiometric chromium based layer may be up to 10µm, up to 9µm, up to 8µm, up to 7µm, up to 6µm, up to 5µm, up to 4µm, up to 3µm, or up to 2µm. A thicker sub-stoichiometric chromium based first layer, such as a sub stoichiometric chromium nitride layer, allows for greater change in height of the support elements and the provision of the more compressively stressed second layer assists in reduce or eliminating the risk of cracking occurring during dimensional change. Such thick first layers would not have been possible without the provision of the second layer which is more compressively stressed than the first layer.

According to a second aspect of the present disclosure, there is provided an object table for an exposure apparatus for a semiconductor manufacturing process comprising an object holder according to the first aspect.

According to a third aspect of the present disclosure, there is provided optical element for an exposure apparatus for a semiconductor manufacturing process, such as a lithographic apparatus, the optical element comprising at least two layers, wherein a first of the at least two layers comprises a metal-Si multilayer, metal-Ge multilayer, or a sub-stoichiometric chromium based first layer configured to selectively change in shape via thermal treatment of the first layer, and of which a layer thickness may locally have been reduced via thermal laser treatment, and wherein a second layer of the at least two layers is more compressively stressed than the first layer of the at least two layers, as has further been detailed above. As with the first aspect, the metal of the metal-Si multilayer and/or metal-Ge multilayer may be selected from titanium, molybdenum, or any combination thereof. The optical element may be a mirror block which typically has mirror surfaces on sides thereof for the purpose of an interferometric object table positioning system. As such, the optical element according to the third aspect of the present disclosure is similar to the object holder according to the first aspect of the present disclosure in that they both are suitable for use in an exposure apparatus for a semiconductor manufacturing process and in that they both comprise two layers, the first of which is a sub-stoichiometric chromium based layer or a metal-Si multilayer or a metal-Ge multilayer configured to change size to control the shape of a surface and of which a layer thickness may locally have been reduced via thermal laser treatment. In addition, both have a second layer which is more compressively stressed than the first layer.

It was not previously possible to correct deformation in the surface of a mirror after IBF correction and application of the mirror layer. Such deformations may arise in the mirror layer itself and from the assembly process. The present disclosure allows for deformations to be corrected by selective heating of the metal-Si multilayer, metal-Ge multilayer, and/or substoichiometric chromium based layer even after the mirror surface has been provided. As described, the provision of a more compressively stressed layer serves to mitigate the risk of cracking occurring when deformations are corrected by selective heating.

According to a fourth aspect of the present disclosure, there is provided an apparatus for controlling the flatness of a surface, the apparatus comprising the object holder or optical element according to the present disclosure and a means for changing a phase configuration of the metal-Si multilayer, metal-Ge multilayer, and or substoichiometric chromium based layer, such as a substoichiometric chromium nitride layer.

It will be appreciated that controlling the flatness does not necessarily mean making the surface as flat as possible, since it may be necessary to correct for errors in other parts of a system to which the apparatus is applied by providing an un-flat surface such that when a substrate is engaged with the surface, the substrate is deformed into a desired shape.

The means for changing the phase configuration may be a laser heater. A laser is preferred due to its high accuracy.

According to a fifth aspect of the present disclosure, there is provided an exposure apparatus for a semiconductor manufacturing process, such as a lithographic apparatus or tool, comprising an object holder according to the first aspect, an object table according to the second aspect, an optical element according to the third aspect, or an apparatus according to the fourth aspect of the present disclosure.

According to a sixth aspect of the present disclosure, there is provided a method of correcting the flatness of a surface of an object holder or optical element of an exposure apparatus for semiconductor manufacturing processes, such as a lithographic apparatus, the method comprising: providing a surface comprising at least two layers wherein a first of the at least two layers comprises at least one material capable of volume change upon heating, as defined above, such as a substoichiometric chromium based layer or a metal-Si multilayer or a metal-Ge multilayer, configured to provide a selectively changeable height via thermal laser treatment of the first layer, and wherein a second of the at least two layers is more compressively stressed than the first of the at least two layers, and wherein the method further includes controlling the flatness of the surface via thermal laser treatment of the first layer, optionally wherein the metal is selected from titanium, molybdenum, or any combination thereof.

As described above, it is possible to correct the shape of a surface by providing a surface with a phase change material, namely a metal-Si or -Ge multilayer and/or a sub-stoichiometric chromium based layer, that allows for the control of the height of areas of the surface. Previously, this was not possible to do in situ.

Correcting the flatness of the surface may be achieved by selectively heating the material to a predetermined temperature and annealing, by laser heating.

Controlling the flatness of the surface preferably takes place within an exposure apparatus for semiconductor manufacturing processes, such as a lithographic apparatus, for which purpose the exposure apparatus may comprise a heater such as a laser heater, configured to subject the object holder to localized heating.

It was previously not possible to adjust the shape of a surface within a lithographic apparatus due to the risk of particle contamination. The present disclosure overcomes this shortcoming by allowing for *in situ* adjustment of the shape of a surface by way of selectively heating a metal-Si multilayer, a metal-Ge multilayer, and/or a sub-stoichiometric chromium based layer.

According to a seventh aspect of the present disclosure, there is provided the use of an object holder for an exposure apparatus for semiconductor manufacturing processes according to the first aspect, an object table for an exposure apparatus for semiconductor manufacturing processes according to the second aspect, an optical element for an exposure apparatus for semiconductor manufacturing processes according to the third aspect, an exposure apparatus for semiconductor manufacturing processes according to the fourth aspect, an exposure apparatus for semiconductor manufacturing processes, such as a lithographic apparatus or tool, according to the fifth aspect, or a method according to the sixth aspect of the present disclosure in an exposure apparatus for a semiconductor manufacturing process or in a semiconductor manufacturing process, such as a lithographic method or apparatus.

Various aspects and features of the invention set out above or below may be combined with various other aspects and features of the invention as will be readily apparent to the skilled person. All such combinations are explicitly considered and disclosed herein.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2a is a schematic depiction of a cross-section of a surface according to the present disclosure;
- Figure 2b is a schematic depiction of a cross-section of a burl according to the present disclosure; and
- Figure 3 is a schematic depiction of an optical element 18 according to the present disclosure.

### DETAILED DESCRIPTION

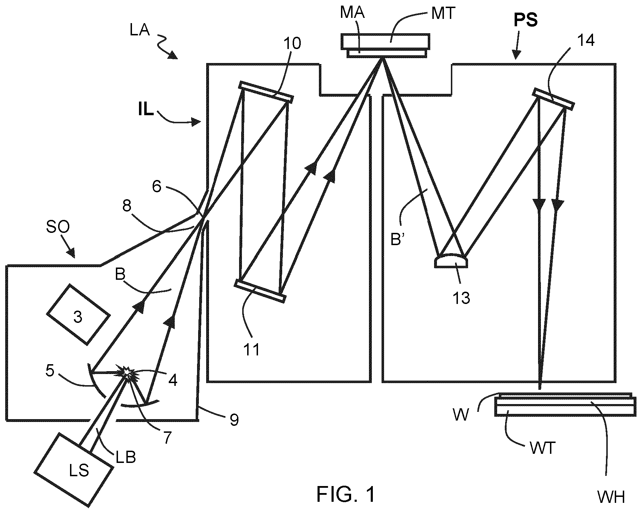

Figure 1 shows a lithographic system comprising a radiation source SO and a lithographic apparatus LA. Although a lithographic system is depicted and referenced in the following description, the present disclosure is applicable to other exposure apparatus for semiconductor manufacturing processes, such as inspection apparatuses and metrology apparatuses. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and an object table WT. The object table WT may comprise an object holder WH configured to support an object W. The object W may be provided in the form of a substrate. The object table WT may be provided in the form of a substrate table. The object holder WH may be provided in the form of a substrate clamp. The substrate may be a wafer.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system LS, which may, for example, include a CO₂ laser, is arranged to deposit energy via a laser beam LB into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam LB is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure, which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system LS may be spatially separated from the radiation source SO. Where this is the case, the laser beam LB may be passed from the laser system LS to the radiation source SO with the aid of a beam delivery system (not shown) comprising, for example, suitable directing mirrors and/or a beam expander, and/or other optics. The laser system LS, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

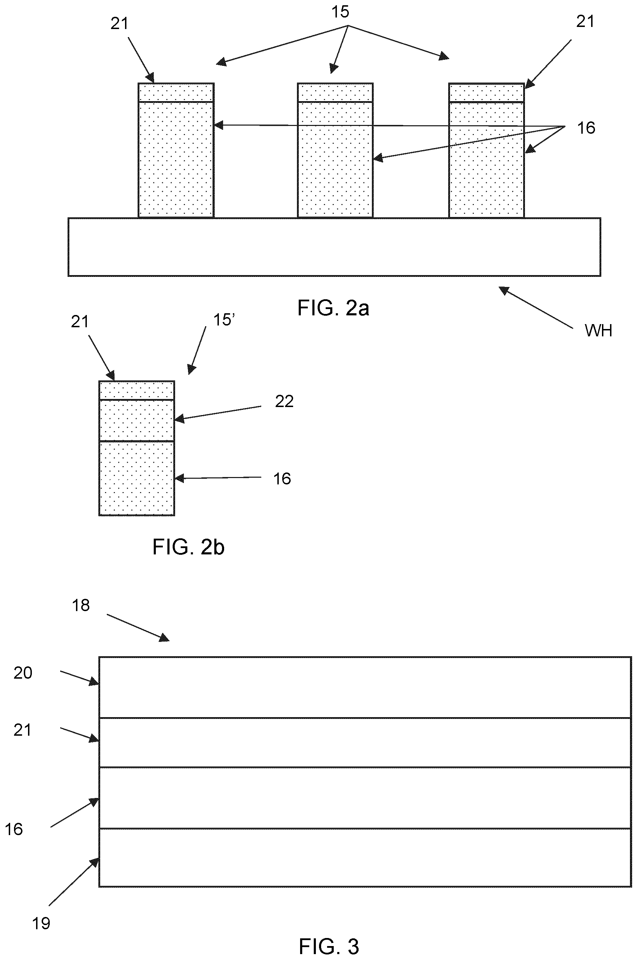

Figure 2a is a schematic depiction of a cross-section of a surface according to the present disclosure. Three burls 15 are depicted, although it will be appreciated that there will be a plurality of burls provided on a surface. The burls 15 comprise, as the first layer, a metal-Si multilayer, such as Ti-Si multilayer or a Mo-Si multilayer or a sub stoichiometric chromium based layer, such as a substoichiometric chromium nitride layer 16. A metal-Ge multilayer may alternatively or additionally be provided. It will be appreciated that reference to a metal-Si multilayer equally applies to a metal-Ge multilayer and/or chromium nitride layer. A second layer 21 which is more compressively stressed than layer 16 is provided. The second layer 21 may be the same compound as the layer 16, or may be a different compound. In either case, second layer 21 is more compressively stressed than layer 16 in order to mitigate the risk of cracking of the burl 15. The layers are drawn not necessarily to scale.

In use, individual burls 15 are controlled in height by the selective heating and annealing of the metal-Si multilayer or sub stoichiometric chromium based layer 16 forming at least part of the burls 15. A pulsed laser may be used. The heat source may be focused on a single burl or a group of burls. The degree of heating and rate of cooling can be controlled by adjusting the intensity and duration of laser pulses. By adjusting the intensity and duration of laser pulses, it is possible to provide the desired surface shape by adjusting the heights of the burls 15. The change in height of the burls is stable in the normal operating temperature range of the substrate holder WH, which may be from 0°C to 100°C such that a change of phase and physical properties is only enacted by the intended heat source.

Figure 2b is a schematic depiction of a cross-section of a burl 15' according to the present disclosure. Burl 15' may be an alternative for all or for some of the burls 15 as shown in figure 2a, of an object holder according to the present disclosure. In addition to the second layer 21 and the first layer 16 as described above, the burl 15' in addition has an intermediate chromium nitride notch absorption layer 22 in accordance with the description of such notch absorption layer above. The layers are drawn not necessarily to scale.

Figure 3 is a schematic depiction of an optical element 18 according to the present disclosure. The optical element comprises a base layer 19 which supports a metal-Si multilayer 16. In embodiments, there may be a chromium nitride layer and/or a metal-Ge multilayer in addition to or instead of the metal-Si multilayer. The optical element has a top layer in the form of a mirror layer 20 which is configured to reflect incident light. The provision of the metal-Si multilayer 16, which can be adjusted by selective heating, allows the mirror layer 20 to be adjusted as required. Without the metal-Si multilayer 16, there is no way of changing the shape of the mirror layer 20 within a lithographic apparatus since other techniques generate contaminants and/or are not viable to do within a lithographic apparatus. The optical element also includes a layer of sub-stoichiometric chromium nitride 21, in the present embodiment between the layers 16 and 20. The layer of sub-stoichiometric chromium nitride 21 is more compressively stressed than layer 16 as detailed above. In an embodiment, the mirror layer 20 may also be a multilayer. In an embodiment, such a top mirror layer may be provided, which is additionally formed as a second, more compressively stressed layer in accordance with the present disclosure. Such a top layer would thus serve as mirror as well as the compressively stressed layer.

It will be appreciated that optical elements for use in lithography apparatus may already include a chromium nitride layer. It has not previously been recognised that it is possible to adjust the shape of the surface of an optical element by densifying chromium nitride. As such, the method according to the present invention can be used to recondition existing optical elements when this was previously not thought to be possible without using processes which are less sensitive and which also have the potential to generate unwanted particulates. Since no particulates are generated by the methods described herein, they are suitable for use *in situ,* which has previously not been possible. Furthermore, where the heat source is a laser, the laser can also be used to clean surfaces which are contaminated with particles and/or organic contaminants. In addition, it has not previously been recognised that applying a second layer which is more compressively stressed than a first layer may serve to mitigate the risk of cracking upon subjecting said first layer to laser heat for reducing its thickness.

The present disclosure can be used to control the shape of the surface of electrostatic wafer clamps, reticle clamps, vacuum wafer chucks and mirror blocks, amongst others.

It will be understood that references to a plurality of features may be interchangeably used with references to singular forms of those features, such as for example "at least one" and/or "each". Singular forms of a feature, such as for example "at least one" or "each," may be used interchangeably.

Although embodiments of the invention have been described in connection with a substrate, a substrate holder and a substrate table, in other embodiments the invention may be used to clamp a mask MA (or other patterning device) to a support structure MT of a lithographic apparatus (see Figure 1), or to clamp some other object.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions. An object holder according to an embodiment of the invention may form part of a lithographic tool.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Aspects of the present disclosure are described in the following numbered clauses:
1. An object holder configured to support an object used in an exposure apparatus for a semiconductor manufacturing process, the object holder comprising a plurality of support elements, preferably being a plurality of burls, wherein the plurality of support elements define a support surface,
   - wherein the plurality of support elements comprise at least two layers;
   - wherein a first of the at least two layers is a substoichiometric chromium based layer or a metal-Si multilayer or a metal-Ge multilayer, configured to provide a selectively changeable height of individual support elements via thermal treatment of the first layer;
   - wherein a second of the at least two layers is more compressively stressed than the first of the at least two layers, and wherein the second layer is located closer to a free end of the support element than said first layer, optionally wherein a layer thickness of said first layer of at least some of the plurality of support elements has been reduced via thermal laser treatment.
2. The object holder according to clause 1, wherein the first layer is a sub stoichiometric chromium based layer, optionally sub stoichiometric chromium nitride (CrₓN), optionally wherein 0.3 ≤ x ≤ 0.8.
3. The object holder according to any preceding clause, wherein the second layer is i) a chromium based layer, optionally a chromium nitride (CrₓN) layer, optionally wherein 0.3 ≤ x ≤ 0.8 , or ii) a titanium based layer, such as titanium nitride, or iii) is a diamond-like carbon (DLC) layer.
4. The object holder according to any preceding clause, wherein the second layer of the at least two layers has been deposited via HiPIMS, ion beam sputtering, magnetron sputtering with substrate bias, arc evaporation, or plasma enhanced chemical vapor deposition, preferably wherein said second layer has been provided via a HiPIMS deposition process.
5. The object holder according to any preceding clause, wherein the second layer is a top layer at the free end of the support element.
6. The object holder according to any preceding clause, wherein the metal is molybdenum or titanium or any combination thereof.
7. The object holder according to any preceding clause, wherein the second of the at least two layers has a compressive stress of from around 500 MPa to around 900 MPa, from around 600 MPa to around 800 MPa, at least 500 MPa, at least 600 MPa, at least 700 MPa, at least 800 MPa, at least 900 MPa, or at least 1000 MPa.
8. The object holder according to any preceding clause, wherein the second of the at least two layers has a thickness of from around 500 nm to around 2000 nm.
9. The object holder according to any preceding clause, wherein the support elements comprise one or more additional layers in addition to the first and second layers.
10. The object holder according to any preceding clause, wherein a third layer is provided between the first and second layers
11. The object holder according to clause 10, wherein at least one of the one or more layers comprises silicon nitride.
12. The object holder according to clause 10 or clause 11, wherein at least one of the one or more additional layers is at an opposite end to the free end.
13. The object holder according to any preceding clause, wherein the plurality of support elements additionally comprise a third layer, the third layer being a notch absorption layer which has such a low volume density that the notch absorption layer can be compressed by a compaction in the layer volume in the case of mechanical action by a foreign particle without compromising the flatness of the support surface.
14. The object holder according to clause 13, wherein the third layer is located between the first and second layers.
15. The object holder according to any preceding clause, wherein the plurality of support elements are burls.
16. The object holder according to any preceding clause, wherein the object holder is a wafer holder, such as a wafer clamp, preferably an electrostatic wafer clamp, or a wafer table, or wherein the object holder is a reticle holder, such as a reticle table or a reticle clamp.
17. The object holder of any preceding clause, wherein the thickness of the first of the at least two layers comprising a metal-Si multilayer, metal-Ge multilayer, and/or sub stoichiometric chromium based layer is up to around 1400 nm, up to around 1300 nm, up to around 1200 nm, up to around 1100 nm, up to around 1000 nm, up to around 900 nm, up to around 800 nm, up to around 700nm, up to around 600 nm, up to around 500 nm, up to around 400 nm, up to around 300 nm, up to around 200 nm or up to around 100 nm, optionally wherein the thickness of the sub stoichiometric chromium based layer may be up to 10µm, up to 9µm, up to 8µm, up to 7µm, up to 6µm, up to 5µm, up to 4µm, up to 3µm, or up to 2µm
18. The object holder of any preceding clause, wherein the thickness of the layers in the multilayer or layer range from around 2 nm to around 100 nm, optionally from around 10 nm to around 20 nm.
19. An object table for an exposure apparatus for a semiconductor manufacturing process comprising an object holder according to any preceding claim.
20. An optical element for an exposure apparatus for a semiconductor manufacturing process, the optical element comprising at least two layers, wherein a first of the at least two layers comprises a metal-Si multilayer and/or metal-Ge multilayer and/or sub stoichiometric chromium based layer configured to selectively change in shape via thermal treatment of the metal-Si multilayer, metal-Ge multilayer, and/or substoichiometric chromium based layer, and wherein a second of the at least two layers is more compressively stressed than the first of the at least two layers, optionally wherein the metal is selected from titanium, molybdenum, or any combination thereof, optionally wherein the optical element is a mirror block, optionally wherein a layer thickness of said first layer has been reduced, preferably locally, via thermal laser treatment.
21. An apparatus for controlling the flatness of a surface, the apparatus comprising the object holder or optical element according to any preceding clause and a means for changing a phase configuration of the metal-Si multilayer, metal-Ge multilayer, and/or substoichiometric chromium based layer, the means comprising a heater, optionally wherein the means comprises a laser heater.
22. An exposure apparatus for a semiconductor manufacturing process, such as a lithographic apparatus or tool, comprising the object holder of any of clauses 1 to 18, the object table of clause 19, the optical element of clause 20, or the apparatus of clause 21.
23. A method of correcting the flatness of a surface of an object holder or optical element of an exposure apparatus for a semiconductor manufacturing process, such as a lithographic apparatus, the method comprising: providing a surface comprising at least two layers wherein a first of the least two layers comprises at least one material capable of volume change upon heating and controlling the flatness of the surface via thermal laser treatment of the at least one material capable of volume change upon heating, wherein the at least one material capable of volume change upon heating is a substoichiometric chromium based layer or a metal-Si multilayer or a metal-Ge multilayer, and wherein a second of the at least two layers is more compressively stressed than the first of the at least two layers, optionally wherein the metal is selected from titanium, molybdenum, or any combination thereof.
24. The method according to clause 24, wherein correcting the flatness of the surface is achieved by selectively heating the at least one material to a predetermined temperature and annealing, optionally by laser heating.
25. The method according to any one of clauses 23 - 24, the method being of correcting the flatness of a surface of an object holder according to any one of clauses 1 - 18, the surface being a support surface having a plurality of support elements, wherein said volume change is to selectively adjust the height of a support element.
26. The method according to any one of clauses 23 - 25, wherein controlling the flatness of the surface takes place within an exposure apparatus for a semiconductor manufacturing process, optionally a lithographic apparatus.
27. A method of selectively adjusting a height of a support element of an object holder according to any one of the above object holder clauses, comprising the step of reducing a layer thickness of the first layer of the support element via thermal laser treatment of that support element.
28. The use of an object holder according to any of clauses 1 to 18, an object table according to clause 19, an optical element for an exposure apparatus for a semiconductor manufacturing process according to clause 20, an apparatus according to clause 21, an exposure apparatus for a semiconductor manufacturing process to clause 22, or a method according to any of clauses 23 to 27 in an exposure apparatus for a semiconductor manufacturing process or in a semiconductor manufacturing process, optionally a lithographic method or apparatus.

## Claims

1. An object holder configured to support an object used in an exposure apparatus for a semiconductor manufacturing process, the object holder comprising a plurality of support elements, wherein the plurality of support elements define a support surface,
- wherein the plurality of support elements comprise at least two layers;
- wherein a first of the at least two layers is a substoichiometric chromium based layer or a metal-Si multilayer or a metal-Ge multilayer, configured to provide a selectively changeable height of individual support elements via thermal treatment of the first layer;
- wherein a second of the at least two layers is more compressively stressed than the first of the at least two layers, and wherein the second layer is located closer to a free end of the support element than said first layer, wherein a layer thickness of said first layer of at least some of the plurality of support elements has been reduced via thermal laser treatment.

2. The object holder according to claim 1, wherein the first layer is a sub stoichiometric chromium based layer, optionally sub stoichiometric chromium nitride (CrₓN), optionally wherein 0.3 ≤ x ≤ 0.8.

3. The object holder according to any preceding claim, wherein the second layer is i) a chromium based layer, optionally a chromium nitride (CrₓN) layer, optionally wherein 0.3 ≤ x ≤ 0.8 , or ii) a titanium based layer, such as titanium nitride, or iii) is a diamond-like carbon (DLC) layer.

4. The object holder according to any preceding claim, wherein the second layer of the at least two layers has been deposited via HiPIMS, ion beam sputtering, magnetron sputtering with substrate bias, arc evaporation, or plasma enhanced chemical vapor deposition process, preferably wherein said second layer has been provided via a HiPIMS deposition process.

5. The object holder according to any preceding claim, wherein the second layer is a top layer at the free end of the support element.

6. The object holder according to any preceding claim, wherein the second of the at least two layers has a compressive stress of from around 500 MPa to around 900 MPa, from around 600 MPa to around 800 MPa, at least 500 MPa, at least 600 MPa, at least 700 MPa, at least 800 MPa, at least 900 MPa, or at least 1000 MPa, and/or
wherein the second of the at least two layers has a thickness of from around 500 nm to around 2000 nm.

7. The object holder according to any preceding claim, wherein the support elements comprise one or more additional layers in addition to the first and second layers, optionally
wherein a third layer is provided between the first and second layers, optionally
wherein at least one of the one or more additional layers comprises silicon nitride, optionally wherein at least one of the one or more additional layers is at an opposite end to the free end.

8. The object holder according to any preceding claim, wherein the object holder includes a base body formed from at least one board having an upper side, wherein the plurality of support elements are arranged on the upper side of the at least one board and form a contact surface with a predetermined flatness for contacting the object, wherein a third layer has been provided, preferably between the first and second layers, which third layer is a notch absorption layer which has such a low volume density that the notch absorption layer can be compressed by a compaction in the layer volume in the case of mechanical action by a foreign particle without compromising the flatness of the contact surface, optionally
wherein the plurality of support elements are burls.

9. The object holder according to any preceding claim, wherein the object holder is a wafer holder, such as a wafer clamp, preferably an electrostatic wafer clamp, or a wafer table, or wherein the object holder is a reticle holder, such as a reticle table or a reticle clamp.

10. An optical element for an exposure apparatus for a semiconductor manufacturing process, the optical element comprising at least two layers, wherein a first of the at least two layers comprises a metal-Si multilayer and/or metal-Ge multilayer and/or sub stoichiometric chromium based layer configured to selectively change in shape via thermal treatment of the metal-Si multilayer, metal-Ge multilayer, and/or chromium based layer, wherein a layer thickness of said first layer has been locally reduced via thermal laser treatment, and wherein a second of the at least two layers is more compressively stressed than the first of the at least two layers, optionally wherein the metal is selected from titanium, molybdenum, or any combination thereof, optionally wherein the optical element is a mirror block.

11. An exposure apparatus for a semiconductor manufacturing process, such as a lithographic apparatus or tool, comprising the object holder of any of claims 1 to 9, or, the optical element of claim 10, and optionally means for changing a phase configuration of the metal-Si multilayer, metal-Ge multilayer, and/or substoichiometric chromium based layer, the means comprising a laser heater.

12. A method of correcting the flatness of a surface of an object holder or optical element of an exposure apparatus for a semiconductor manufacturing process, such as a lithographic apparatus, the method comprising: providing a surface comprising at least two layers wherein a first of the least two layers is a substoichiometric chromium based layer or a metal-Si multilayer or a metal-Ge multilayer, configured to provide a selectively changeable height via thermal laser treatment of the first layer, wherein a second of the at least two layers is more compressively stressed than the first of the at least two layers, and wherein the method further includes controlling the flatness of the surface via thermal laser treatment of the material of the first layer.

13. The method according to claim 12, wherein the metal is selected from titanium, molybdenum, or any combination thereof,
optionally wherein correcting the flatness of the surface is achieved by selectively heating the at least one material to a predetermined temperature and annealing by laser heating.

14. The method according to claim 12 or claim 13, wherein the method being of correcting the flatness of a surface of an object holder according to any one of claims 1 - 9, the surface being a support surface having a plurality of support elements, wherein said volume change is to selectively adjust the height of a support element.

15. The method according to any of claims 12 to 14, wherein controlling the flatness of the surface takes place within an exposure apparatus for a semiconductor manufacturing process, optionally a lithographic apparatus
